# EUROPÄISCHE PATENTSCHRIFT

(11) **EP 2 609 617 B1**
(45) Veröffentlichungstag und Bekanntmachung des Hinweises auf die Patenterteilung: **15.07.2020**
(21) Anmeldenummer: 11767388.9
(22) Anmeldetag: 25.08.2011
(51) Int. Cl.: H01L 21/00, H01L 21/677, H01L 21/67

(54) **VORRICHTUNG UND VERFAHREN ZUR WÄRMEBEHANDLUNG MEHRERER MEHRSCHICHTKÖRPER**
DEVICE AND METHOD FOR HEAT-TREATING A PLURALITY OF MULTI-LAYER BODIES
DISPOSITIF ET PROCÉDÉ DE TRAITEMENT THERMIQUE DE PLUSIEURS CORPS MULTICOUCHES

(30) Priorität: 27.08.2010 EP 10174325
(43) Veröffentlichungstag der Anmeldung: 03.07.2013
(73) Patentinhaber: (CNBM) Bengbu Design & Research Institute for Glass Industry Co., Ltd., Bengbu (CN)
(72) Erfinder: FÜRFANGER, Martin, 85643 Steinhörung (DE); JOST, Stefan, 81543 München (DE)
(74) Vertreter: Gebauer, Dieter Edmund
(86) Internationale Anmeldenummer: PCT/EP2011/064683
(87) Internationale Veröffentlichungsnummer: WO 2012/025607

(56) Entgegenhaltungen:
- EP-A2- 2 060 659
- WO-A1-2007/058702
- WO-A1-2010/067544
- WO-A2-2004/036630
- WO-A2-2009/033674
- DE-A1-102008 022 784
- JP-A- 2005 206 852
- US-A- 5 674 786
- US-A- 5 892 886
- US-A1- 2001 038 002
- US-A1- 2010 139 557

## Beschreibung

Die Erfindung betrifft eine Vorrichtung und ein Verfahren zur Wärmebehandlung von Mehrschichtkörpern, insbesondere zum Temperieren von Vorläuferschichten zur Herstellung von Halbleiterschichten, die beispielsweise als Absorber in Dünnschichtsolarzellen verwendet werden können.

Photovoltaische Schichtsysteme zur direkten Umwandlung von Sonnenstrahlung in elektrische Energie sind hinreichend bekannt. Die Materialien und die Anordnung der Schichten sind so abgestimmt, dass einfallende Strahlung von einer oder mehreren halbleitenden Schichten mit möglichst hoher Strahlungsausbeute direkt in elektrischen Strom umgewandelt wird. Photovoltaische und flächig ausgedehnte Schichtsysteme werden als Solarzellen bezeichnet.

Solarzellen enthalten in allen Fällen Halbleitermaterial. Solarzellen, die zur Bereitstellung einer ausreichenden mechanischen Festigkeit Trägersubstrate benötigen, werden als Dünnschichtsolarzellen bezeichnet. Aufgrund der physikalischen Eigenschaften und der technologischen Handhabbarkeit sind Dünnschichtsysteme mit amorphem, mikromorphem oder polykristallinem Silizium, Cadmium-Tellurid (CdTe), Gallium-Arsenid (GaAs) oder Kupfer-Indium-(Gallium)-Selenid-Sulfid (Cu(In,Ga)(S,Se)₂) besonders für Solarzellen geeignet. Der pentanäre Halbleiter Cu(In,Ga)(S,Se)₂ gehört zur Gruppe der Chalkopyrit-Halbleiter, die häufig als CIS (Kupferindiumdiselenid oder -sulfid) oder CIGS (Kupferindiumgalliumdiselenid, Kupferindiumgalliumdisulfid oder Kupferindiumgalliumdisulfoselenid) bezeichnet werden. S kann in der Abkürzung CIGS für Selen, Schwefel oder eine Mischung beider Chalkogene stehen.

Bekannte Trägersubstrate für Dünnschichtsolarzellen enthalten anorganisches Glas, Polymere, Metalle oder Metalllegierungen und können in Abhängigkeit von Schichtdicke und Materialeigenschaften als starre Platten oder biegsame Folien ausgestaltet sein. Aufgrund der weitreichend verfügbaren Trägersubstrate und einer einfachen monolithischen Serienverschaltung können großflächige Anordnungen von Dünnschichtsolarzellen kostengünstig hergestellt werden.

Dünnschichtsolarzellen zeigen allerdings im Vergleich zu Solarzellen mit kristallinem oder multikristallinem Silizium eine geringere Strahlungsausbeute und einen geringeren elektrischen Wirkungsgrad. Dünnschichtsolarzellen basierend auf Cu(In,Ga)(S,Se)₂ zeigen elektrische Wirkungsgrade, die annähernd mit multikristallinen Silizium-Solarzellen vergleichbar sind. CI(G)S-Dünnschichtsolarzellen benötigen eine Pufferschicht zwischen typisch p-leitendem CI(G)S-Absorber und typisch n-leitender Frontelektrode, die üblicherweise Zinkoxid (ZnO) umfasst. Die Pufferschicht kann eine elektronische Anpassung zwischen Absorbermaterial und Frontelektrode bewirken. Die Pufferschicht enthält beispielsweise eine Cadmium-Schwefel-Verbindung. Eine Rückelektrode mit beispielsweise Molybdän wird direkt auf Trägersubstraten abgeschieden.

Eine elektrische Schaltung von mehreren Solarzellen wird als Photovoltaik- oder Solarmodul bezeichnet. Die Schaltung von Solarzellen wird in bekannten witterungsstabilen Aufbauten dauerhaft vor Umwelteinflüssen geschützt. Üblicherweise sind eisenarme Natron-Kalk-Gläser und haftvermittelnde Polymerfolien mit den Solarzellen zu einem bewitterungsstabilen Photovoltaikmodul verbunden. Die Photovoltaikmodule können über Anschlussdosen in eine Schaltung von mehreren Photovoltaikmodulen eingebunden sein. Die Schaltung von Photovoltaikmodulen ist über bekannte Leistungselektronik mit dem öffentlichen Versorgungsnetz oder einer autarken elektrischen Energieversorgung verbunden.

Ein mögliches Verfahren zur Herstellung von Dünnschichthalbleitern beispielsweise aus Cu(In,Ga)(S,Se)₂ besteht aus einem Zweistufenprozess. Solche zweistufigen Verfahren sind beispielsweise aus J. Palm et al., "CIS module pilot processing applying concurrent rapid selenization and sulfurization of large area thin film precursors", Thin Solid Films 431-432, S. 414-522 (2003) bekannt. Dabei wird zunächst eine Rückelektrode aus Molybdän auf ein Substrat, beispielsweise ein Glassubstrat, aufgebracht. Die Molybdänschicht wird beispielsweise mit einem Laser strukturiert. Anschließend werden auf die Molybdänschicht verschiedene Vorläuferschichten aus Kupfer, Indium und Gallium abgeschieden, beispielsweise durch Magnetron-Kathodenzerstäubung. Außerdem werden eine Selen-Schicht und/oder eine Schwefel-Schicht durch thermisches Verdampfen auf der Schichtfolge abgeschieden. Der so entstandene Mehrschichtkörper mit den Vorläuferschichten wird in einem zweiten Prozess wärmebehandelt. Durch die Wärmebehandlung erfolgt die eigentliche Kristallbildung und Phasenumwandlung der Vorläuferschichten zur eigentlichen Halbleiterschicht.

Die Wärmebehandlung erfolgt beispielsweise in In-Line-Anlagen, bei denen die unterschiedlichen Prozessschritte in verschiedenen Kammern erfolgen. Die verschiedenen Kammern werden hintereinander in einer Prozessstraße durchlaufen. In einem vereinfachten Aufbau besteht eine In-Line-Anlage aus einer Ladestation, in der die Anlage mit unbehandelten Mehrschichtkörpern beladen wird. Anschließend werden die Mehrschichtkörper über eine Einschleusekammer in die In-Line-Anlage eingefahren. In verschiedenen Heizkammern werden die Mehrschichtkörper mit Aufheizgeschwindigkeiten bis zu 50 °C/s sehr schnell erwärmt und einem bestimmten Temperaturverlauf ausgesetzt. Die Erwärmung erfolgt beispielsweise durch elektrisch betriebene Heizstrahler. Das Verfahren zur schnellen thermischen Prozessierung von einzelnen Vorläuferschichten zu einer Halbleiterverbindung wird üblicherweise als Rapid Thermal Processing (RTP) bezeichnet. Anschließend wird der Mehrschichtkörper in Kühlkammern und/oder einer Kühlstrecke abgekühlt und aus der Anlage ausgeschleust. Ein Verfahren zur schnellen thermischen Prozessierung von Chalkopyrit-Halbleitern zur Verwendung als Absorber in Dünnschichtsolarzellen ist beispielsweise aus EP 0 662 247 B1 bekannt.

Die Wärmebehandlung des Mehrschichtkörpers ist ein kostenintensiver und anspruchsvoller Prozess in der Herstellung von Dünnschichtsolarzellen. Der Prozess erfordert hohe Temperaturen und eine genaue Kontrolle der Prozessatmosphäre.

Zur besseren Kontrolle des Wärmebehandlungsprozesses kann der Prozessraum um den Mehrschichtkörper, beispielsweise durch eine temporäre Prozessbox, begrenzt werden, wie aus DE 10 2008 022 784 A1 bekannt ist. Durch Begrenzung des Prozessraumes bleibt der Partialdruck der leicht flüchtigen Chalkogenkomponenten wie Selen oder Schwefel während der Wärmebehandlung weitestgehend konstant. Außerdem wird die Exposition der Prozesskammer mit korrosiven Gasen reduziert.

Alternativ kann die Wärmebehandlung der Mehrschichtkörper im Batchbetrieb in Stapel-Öfen erfolgen. Ein solcher Stapel-Ofen ist aus WO 01/29902 A2 bekannt. Der Stapel-Ofen dient zum gleichzeitigen Erwärmen und späteren Abkühlen mehrerer Mehrschichtkörper in einer einzelnen Kammer. Das erhöht die Anlagen-Taktzeit und verringert damit den Anlagendurchsatz im Vergleich zu In-line-Anlagen, bei denen Aufheizen und Abkühlen in verschiedenen Kammern realisiert wird. Der gesamte Stapel-Ofen mit Ofenwänden und Ofeneinbauten wird parasitär aufgeheizt und während des Kühlprozesses wieder abgekühlt. Im Vergleich mit In-Line-Anlagen, bei denen Heiz- und Kühlkammern mit Wänden und Einbauten im kontinuierlichen Betrieb deutlich geringeren Temperaturveränderungen unterliegen, fallen deshalb bei Stapel-Öfen höhere Energiekosten an. Der diskontinuierliche Batchbetrieb der Stapel-Öfen ist schlechter in den gesamten Herstellungsprozess von Solarzellen oder Solarmodulen in einer großtechnischen Fertigung integrierbar, die üblicherweise auf einem In-Line-Prinzip basiert.

JP 2005 206852 A offenbart ein umlaufendes Transportsystem zur Behandlung von Substraten ohne Prozessboxen, bei dem für mehrere Transportreihen jeweils separate Wärmebehandlungskammer vorgesehen sind.

Die Aufgabe der vorliegenden Erfindung liegt darin, die im Stand der Technik bekannten Vorrichtungen zum Wärmebehandeln von Mehrschichtkörpern in vorteilhafter Weise weiterzubilden. Insbesondere soll eine kostengünstige und energiesparende Vorrichtung bereitgestellt werden, bei der der Anlagendurchsatz mindestens verdoppelt wird und sich die Investitionskosten und Betriebskosten nur geringfügig erhöhen.

Diese und weitere Aufgaben werden durch eine Vorrichtung zum kontinuierlichen Wärmebehandeln von mindestens zwei Mehrschichtkörpern gemäß den nebengeordneten Patentansprüchen gelöst. Bevorzugte Ausführungen gehen aus den Unteransprüchen hervor.

Der Ausdruck Mehrschichtkörper beschreibt im Sinne der Erfindung mindestens ein Substrat mit mehreren darauf aufgebrachten gleichen oder verschiedenen Schichten.

Die erfindungsgemäße Vorrichtung zum kontinuierlichen Wärmebehandeln von mindestens zwei Mehrschichtkörpern umfasst mindestens eine Heizkammer und mindestens eine Kühlkammer, die hintereinander angeordnet sind. Die Heizkammer und die Kühlkammer sind bevorzugt durch eine Schleuse getrennt. Die erfindungsgemäße Vorrichtung weist eine Transportvorrichtung auf zum Transportieren der Mehrschichtkörper in die Heizkammer, von der Heizkammer in die Kühlkammer und aus der Kühlkammer heraus. Die Mehrschichtkörper befinden sich in der erfindungsgemäßen Vorrichtung auf mindestens zwei über- bzw. untereinander angeordneten Prozessebenen. In der Heizkammer werden die Mehrschichtkörper durch Absorption von Energie aus elektromagnetischer Strahlung aufgeheizt, bevorzugt durch Absorption von Infrarotstrahlung, besonders bevorzugt durch Absorption von elektromagnetischer Strahlung mit einem Intensitätsmaximum bei einer Wellenlänge von 1 µm bis 2 pm.

Die Heizkammer umfasst mindestens ein erstes Strahlerfeld zum Beheizen eines ersten Mehrschichtkörpers. Unterhalb des ersten Strahlerfelds ist eine erste Prozessebene zur Aufnahme einer ersten Prozessbox für wenigstens einen ersten Mehrschichtkörper angeordnet. Unterhalb der ersten Prozessebene ist ein zweites Strahlerfeld zum Beheizen des wenigstens einen ersten Mehrschichtkörpers und wenigstens eines zweiten Mehrschichtkörpers in einer zweiten Prozessebene angeordnet. Unterhalb des zweiten Strahlerfelds ist die zweite Prozessebene zur Aufnahme einer zweiten Prozessbox für wenigstens den zweiten Mehrschichtkörper angeordnet. Unterhalb der zweiten Prozessebene ist ein drittes Strahlerfeld zum Beheizen des zweiten Mehrschichtkörpers angeordnet. Somit umfasst die Vorrichtung eine erste Prozessebene mit der ersten Prozessbox für wenigstens einen ersten Mehrschichtkörper, welche sich zwischen dem ersten Strahlerfeld und dem zweiten Strahlerfeld mit Heizstrahlern zum Beheizen des ersten Mehrschichtkörpers befindet, und eine zweite Prozessebene mit der zweiten Prozessbox für wenigstens einen zweiten Mehrschichtkörper, welche sich zwischen dem zweiten Strahlerfeld und dem dritten Strahlerfeld mit Heizstrahlern zum Beheizen des zweiten Mehrschichtkörpers befindet.

Durch die Ausdrücke "erstes", "zweites" und "drittes" wird die relative Lage der Strahlerfelder zu den beiden Prozessebenen angegeben, wobei sich das erste Strahlerfeld auf der einen Seite der einen Prozessebene und das zweite Strahlerfeld auf der anderen Seite dieser Prozessebene befindet. Andererseits befindet sich das zweite Strahlerfeld auf der einen Seite der anderen Prozessebene und das dritte Strahlerfeld auf der anderen Seite der anderen Prozessebene. Es versteht sich, dass bei einer Vorrichtung mit mehr als zwei Prozessebenen in entsprechender Weise benachbart zu den beiden äußersten Prozessebenen ein erstes bzw. drittes Strahlerfelder angeordnet ist, wobei sich jeweils ein zweites Strahlerfeld zwischen zwei benachbarten Prozessebenen befindet.

Erfindungsgemäß sind die beiden Strahlerfelder der ersten Prozessebene und die beiden Strahlerfelder der zweiten Prozessebene dazu ausgebildet, die erste Prozessebene und/oder die zweite Prozessebene jeweils mit einer verschiedenen Strahlungsintensität zu bestrahlen. Dies bedeutet, dass das erste und zweite Strahlerfeld so ausgebildet sind, dass sie voneinander verschiedene Strahlungsintensitäten zur Heizung der ersten Prozessebene abgeben können. Die erste Prozessebene kann somit auf den beiden Seiten an denen die Strahlerfelder angeordnet sind, beispielsweise auf ihrer Ober- und Unterseite, mit verschiedenen Strahlungsintensitäten geheizt werden. Hierbei ist die Strahlungsintensität des ersten Strahlerfelds auf der einen Seite der ersten Prozessebene verschieden von der Strahlungsintensität des zweiten Strahlerfelds auf der anderen Seite der ersten Prozessebene. In entsprechender Weise sind das zweite Strahlerfeld und das dritte Strahlerfeld so ausgebildet, dass sie voneinander verschiedene Strahlungsintensitäten zur Heizung der zweiten Prozessebene abgeben können. Die zweite Prozessebene kann somit auf den beiden Seiten an denen die Strahlerfelder angeordnet sind, beispielsweise auf ihrer Ober- und Unterseite, mit verschiedenen Strahlungsintensitäten geheizt werden. Hierbei ist die Strahlungsintensität des zweiten Strahlerfelds auf der einen Seite der zweiten Prozessebene verschieden von der Strahlungsintensität des dritten Strahlerfelds auf der anderen Seite der zweiten Prozessebene.

Wie die Anmelderin festgestellt hat, ist der Wärmeeintrag eines in einer Prozessbox befindlichen Mehrschichtkörpers auf dessen Ober- und Unterseite in der Regel verschieden. Ursache hierfür ist die unterschiedliche thermische Kopplung zwischen Mehrschichtkörper und Prozessbox, beispielsweise durch Wärmeleitung zwischen der Prozessbox und der Unterseite des Mehrschichtkörpers aufgrund der Auflage in der Prozessbox oder durch verschiedene Höhen der Gasatmosphäre auf der Ober- und Unterseite des Mehrschichtkörpers zwischen Mehrschichtkörper und Deckel bzw. Boden der Prozessbox. Eine weitere Ursache kann eine unterschiedliche Erwärmung von Deckel oder Boden der Prozessbox durch die Heizstrahler sein. Zudem kann der Schichtenaufbau des Substrats eine vom Substrat verschiedene thermische Anbindung an die Prozessbox und/oder die Heizstrahler haben.

Im Allgemeinen ist eine möglichst homogene Wärmeverteilung innerhalb eines Mehrschichtkörpers beispielsweise zur kontrollierten Umsetzung der Precursor-Materialien zum Absorber bei einem Dünnschichthalbleiter erwünscht. Die genannten Effekte führen allerdings zu einer unerwünschten Inhomogenität in der Wärmeverteilung im Mehrschichtkörper. Durch die vorliegende Erfindung kann in vorteilhafter Weise durch die unterschiedliche Strahlungsintensität der zu einer selben Prozessebene benachbarten Strahlerfelder eine Homogenisierung der Wärmeverteilung in dem in dieser Prozessebene enthaltenen Mehrschichtkörper erreicht werden. Die vorliegende Erfindung widmet sich somit erstmals der Problematik einer inhomogenen Wärmeverteilung in Mehrschichtkörpern auf mehreren Prozessebenen, indem die beiden Strahlerfelder der ersten Prozessebene und die beiden Strahlerfelder der zweiten Prozessebene dazu ausgebildet sind, die erste Prozessebene und/oder die zweite Prozessebene jeweils mit einer verschiedenen Strahlungsintensität so zu bestrahlen, dass eine homogene Wärmeverteilung in den zu prozessierenden Mehrschichtkörpern erzielt wird.

Die Kühlkammer umfasst mindestens die erste Prozessebene und die zweite Prozessebene, die beispielsweise unterhalb der ersten Prozessebene angeordnet ist. Außerdem umfasst die Kühlkammer eine Kühlvorrichtung zum Kühlen der ersten Prozessebenen und/oder der zweiten Prozessebene.

In einer vorteilhaften Ausgestaltung der erfindungsgemäßen Vorrichtung umfasst die Kühlvorrichtung mindestens drei Kühlplatten. Die Kühlkammer umfasst mindestens eine erste Kühlplatte zum Kühlen des ersten Mehrschichtkörpers. Beispielsweise unterhalb der ersten Kühlplatte ist die erste Prozessebene angeordnet. Beispielsweise unterhalb der ersten Prozessebene ist eine zweite Kühlplatte zum Kühlen des ersten und des zweiten Mehrschichtkörpers angeordnet. Beispielsweise unterhalb der zweiten Kühlplatte ist die zweite Prozessebene und unterhalb der zweiten Prozessebene eine dritte Kühlplatte zum Kühlen des zweiten Mehrschichtkörpers angeordnet. Somit befindet sich die erste Prozessebene zwischen der ersten Kühlplatte und der zweiten Kühlplatte und die zweite Prozessebene zwischen der zweiten Kühlplatte und der dritten Kühlplatte.

Die Abkühlgeschwindigkeit sowie die Temperaturhomogenität über den Mehrschichtkörper wird durch den Abstand der Kühlplatte zum Mehrschichtkörper, durch die Absorptionseigenschaften der Kühlplattenoberfläche und durch die Temperatur der Kühlplatte beeinflusst. Die mittlere Kühlplatte kann beispielsweise aus zwei Elementen bestehen, die unterschiedlich große Abstände zum ersten und zum zweiten Mehrschichtkörper haben und diese unterschiedlich stark kühlen. Die Kühlplatten weisen üblicherweise ein Rohrsystem in ihrem Innern auf und werden mit einem Wärmeträgermedium wie Öl oder Wasser durchflossen. Das Wärmeträgermedium wird außerhalb der Vorrichtung durch ein Kühlaggregat gekühlt. Die Kühlplatten enthalten beispielsweise Edelstahl oder Kupfer.

Eine Vorrichtung mit zwei übereinander angeordneten Prozessebenen ist besonders vorteilhaft, da die Strahlungsenergie des dazwischen liegenden, zweiten Strahlerfeldes besonders effektiv ausgenutzt werden kann. Die elektromagnetische Strahlung, die vom zweiten Strahlerfeld abgestrahlt wird, heizt direkt den ersten und den zweiten Mehrschichtkörper auf der ersten und der zweiten Prozessebene.

In einer bevorzugten Ausgestaltung der erfindungsgemäßen Vorrichtung sind die Strahlerfelder und die Prozessebenen parallel zueinander angeordnet. In einer weiteren bevorzugten Ausgestaltung der erfindungsgemäßen Vorrichtung sind die Kühlplatten und die Prozessebenen parallel zueinander angeordnet.

Bei vorteilhaften Ausgestaltungen der erfindungsgemäßen Vorrichtung sind die Strahlerfelder, Prozessebenen und Kühlplatten vertikal oder horizontal angeordnet. Eine vertikale Anordnung im Sinne der Erfindung bedeutet, dass die Strahlerfelder, Prozessebenen und Kühlplatten näherungsweise parallel zur Anlagengrundfläche angeordnet sind. Für die Heizkammer bedeutet eine vertikale Anordnung: Die erste Prozessebene ist unterhalb des ersten Strahlerfeldes angeordnet und das zweite Strahlerfeld ist unterhalb der ersten Prozessebene angeordnet. Außerdem ist mindestens eine zweite Prozessebene unterhalb des zweiten Strahlerfeldes angeordnet und mindestens ein drittes Strahlerfeld ist unterhalb der zweiten Prozessebene angeordnet. In der Kühlkammer sind die Kühlplatten und Prozessebenen entsprechend untereinander angeordnet. Durch die vertikale Anordnung nimmt die erfindungsgemäße Vorrichtung etwa die gleiche Anlagengrundfläche ein wie eine Vorrichtung nach dem Stand der Technik. Mit der erfindungsgemäßen Vorrichtung können mindestens doppelt so viele Mehrschichtkörper gleichzeitig wärmebehandelt werden wie mit einer Vorrichtung nach dem Stand der Technik. In einer horizontalen Anordnung sind Strahlerfelder, Prozessebenen und Kühlplatten näherungsweise orthogonal zur Anlagengrundfläche angeordnet.

In einer bevorzugten Ausgestaltung der erfindungsgemäßen Vorrichtung sind in der Heizkammer und/oder der Kühlkammer mindestens zwei Mehrschichtkörper, bevorzugt drei Mehrschichtkörper auf mindestens einer Prozessebene in Transportrichtung nebeneinander angeordnet. Die nebeneinander angeordneten Mehrschichtkörper werden vorzugsweise im Gleichtakt durch die Heiz- und Kühlkammer transportiert und dabei prozessiert.

In der erfindungsgemäßen Vorrichtung ist mindestens ein Mehrschichtkörper, bevorzugt zwei Mehrschichtkörper, in einer Prozessbox angeordnet. Die Prozessbox dient zur Begrenzung des Prozessraumes. Erfindungsgemäß weist die erste Prozessebene eine erste Prozessbox für wenigstens einen ersten Mehrschichtkörper und die zweite Prozessebene eine zweite Prozessbox für mindestens einen zweiten Mehrschichtkörper auf.

Die Prozessbox kann als Kasten mit Boden, Deckel und Seitenwänden ausgestaltet sein. Boden, Deckel und Seitenwände können Metall, Glas, Keramik, Glaskeramik oder Graphit enthalten. Boden, Deckel und Seitenwände können transparent, teilweise transparent oder undurchsichtig sein, insbesondere für die elektromagnetische Strahlung der Strahlerfelder. Boden, Deckel und Seitenwände können die elektromagnetische Strahlung der Strahlerfelder absorbieren und selbst aufgeheizt werden. Die aufgeheizten Böden, Deckel oder Seitenwände können dann als sekundäre Wärmequelle zum Aufheizen der Mehrschichtkörper dienen.

Die Prozessboxen können quasi gasdicht oder offen ausgestaltet sein. Die Prozessboxen können bevorzugt eigene Gasanschlüsse aufweisen und während bestimmter Prozessschritte mit einer bestimmten Gasatmosphäre versehen werden. Die Gasatmosphäre kann beispielsweise reaktive Gase wie H₂S, H₂Se, S-Dampf, Se-Dampf oder H₂ sowie Inertgase wie N₂, He oder Ar enthalten.

Prozessboxen können mit mindestens einem Deckel und/oder einem Boden aus einem die elektromagnetische Strahlung des Strahlerfeldes absorbierenden Material, beispielsweise aus Graphit, ausgestaltet sein. Durch das Aufheizen von Boden und Deckel entsteht eine sekundäre Wärmequelle, was zu einer Homogenisierung der Wärmeverteilung führen kann.

Quasi gasdicht bedeutet im Sinne der Erfindung, dass die Prozessbox bis zu einer definierten maximalen Druckdifferenz zwischen dem Innenraum der Prozessbox und der Prozesskammer gasdicht ist. Bei Überschreiten einer definierten maximalen Druckdifferenz kommt es zu einem Druckausgleich zwischen dem Innenraum der Prozessbox und der Prozesskammer. In einer hierfür geeigneten Ausgestaltung wird der Deckel lose auf den Rahmen der Prozessbox aufgelegt. In Abhängigkeit von der Dichtigkeit der Prozessbox kann bei quasi gasdichten Prozessboxen ein Druckunterschied zwischen Innenraum der Prozessbox und der Prozesskammer aufrechterhalten werden. Der freie Austausch von Prozessgas bleibt begrenzt und es bildet sich ein Partialdruckgefälle des Prozessgases.

In einer bevorzugten Ausgestaltung der erfindungsgemäßen Vorrichtung wird eine Prozessbox mit jeweils zwei Mehrschichtkörpern beladen. Mehrschichtkörper zur Herstellung von Halbleiterschichten für Dünnschicht-Solarzellen bestehen üblicherweise aus einem Glassubstrat und einer Abfolge von Vorläuferschichten. Zur Prozessierung von zwei Mehrschichtkörpern in einer Prozessbox können beide Glassubstrate derart nebeneinander angeordnet werden, dass beide Vorläuferschichten nach außen zeigen. Alternativ können beide Vorläuferschichten zueinander gewandt sein. Im zueinander gewandten Fall werden vorzugsweise die beiden Vorläuferschichten durch Beabstandungsmittel voneinander getrennt. Durch den entstandenen Raum kann den Vorläuferschichten ein Prozessgas zugeführt werden.

In der erfindungsgemäßen Vorrichtung werden die Mehrschichtkörper oder die mit Mehrschichtkörpern beladenen Prozessboxen durch einen Transportmechanismus durch die Vorrichtung gefahren. Der Transportmechanismus kann beispielsweise ein Förderband, Förderketten oder einen Schlittenzug enthalten. Der Transportmechanismus kann bevorzugt Rollen enthalten, die besonders bevorzugt über Keilriemen oder Kettenantriebe, bevorzugt mit außerhalb der Prozesskammer liegender Antriebseinheit, synchron angetrieben werden. Der Transportmechanismus enthält bevorzugt durchgehende Quarzrollen oder Stummelrollen, die unterhalb der Mehrschichtkörper oder der Prozessboxen angeordnet sind. Die Stummelrollen können innerhalb oder außerhalb des Strahlungsfeldes der Strahlerfelder angeordnet sein und werden entsprechend mehr oder weniger aufgeheizt. Die Stummelrollen enthalten bevorzugt hochtemperaturbeständige Keramiken wie Si₃N₄ und BN oder Oxidkeramiken wie ZrO₂.

In einer bevorzugten Ausgestaltung der erfindungsgemäßen Vorrichtung sind in der Heizkammer und/oder Kühlkammer mindestens zwei Prozessboxen, bevorzugt drei Prozessboxen auf mindestens einer Prozessebene in Transportrichtung nebeneinander angeordnet. Die nebeneinander angeordneten Prozessboxen werden vorzugsweise im Gleichtakt durch die Heiz- und Kühlkammer transportiert und dabei prozessiert.

In einer bevorzugten Ausgestaltung der erfindungsgemäßen Vorrichtung weist die Kühlkammer eine Konvektionskühlung oder eine Zwangskühlung auf. Bei der Zwangskühlung zirkuliert bevorzugt ein Gasstrom, besonders bevorzugt ein Gasstrom eines Inertgases durch die Kühlkammer. Der Gasstrom wird an den Kühlplatten oder an geeigneten Kühlkörpern abgekühlt. Anschließend werden die aufgeheizten Mehrschichtkörper oder die Prozessboxen durch den Gasstrom gekühlt. Das Gas wird bevorzugt durch einen Ventilator oder ein Gebläse bewegt. Bei der Konvektionskühlung entsteht ein zirkulierender Gasstrom durch das Aufsteigen von erwärmter Luft und das Absinken von kühler Luft.

In einer weiteren bevorzugten Ausgestaltung der erfindungsgemäßen Vorrichtung weist die Heizkammer zwei Reflektoren auf. Der erste Reflektor ist an der der ersten Prozessebene abgewandten Seite des ersten Strahlerfeldes angeordnet. Der zweite Reflektor ist an der der zweiten Prozessebene abgewandten Seite des dritten Strahlerfeldes angeordnet. Die Reflektoren enthalten bevorzugt einen Grundkörper mit oder ohne Beschichtung, wobei der Reflektor eine hohe Reflektivität aufweist im Wellenlängenbereich der elektromagnetischen Strahlung der Strahlerfelder und/oder im Wellenlängenbereich der elektromagnetischen Strahlung, die von dem aufgeheizten Mehrschichtkörper oder der Prozessbox ausgeht. Der Grundkörper enthält beispielsweise eine Keramik, Quarzglas, Metall oder ähnliche für hohe Prozesstemperaturen geeignete Materialien. Die Beschichtung der Reflektoren enthält bevorzugt Metalle wie Gold, Silber, Molybdän, Aluminium, keramische Verbindungen wie Al(MgF₂), Al(SiO), MgF₂, SiO₂, Al₂O₃ oder Quarz-Nanopartikeln.

Ohne Reflektoren trifft die elektromagnetische Strahlung, die von den äußeren Strahlerfeldern in die von den Prozessebenen abgewandten Richtungen abgestrahlt wird, auf die Außenwände der Anlage. Diese Strahlung trägt nur zu einem geringen Teil zum Heizen der Mehrschichtkörper bei. Die Reflektoren reflektieren einen Großteil dieser Strahlung zurück in die Anlage und damit auf die Mehrschichtkörper. Der Wirkungsgrad der Strahlerfelder wird durch die Reflektoren erhöht und der Energiebedarf wird gesenkt.

In einer vorteilhaften Ausgestaltung der erfindungsgemäßen Vorrichtung weist die Heizkammer und/oder die Kühlkammer eine Einrichtung zur Erzeugung eines Vakuums und/oder einer Gasatmosphäre auf. Die Gasatmosphäre enthält bevorzugt ein Prozessgas oder ein Inertgas. Durch mehrmaliges Evakuieren und Fluten der Prozesskammern mit reinen Gasen kann eine definierte Gasatmosphäre erzeugt werden. Heizkammer und Kühlkammer sind bevorzugt durch Schleusen oder Schieber nach außen abgeschlossen und voneinander getrennt, besonders bevorzugt durch vakuumdichte und/oder gasdichte Schleusen.

Eine bevorzugte Ausgestaltung der erfindungsgemäßen Vorrichtung weist mehrere Heizkammern und/oder mehrere Kühlkammern auf, die von den Mehrschichtkörpern hintereinander durchfahren werden. Eine besonders bevorzugte Ausgestaltung der erfindungsgemäßen Vorrichtung weist zwei bis sechs Heizkammern und zwei bis sechs Kühlkammern auf. Die verschiedenen Heizkammern und Kühlkammern können unterschiedliche Temperaturen und unterschiedliche Heiz- beziehungsweise Kühlleistungen aufweisen. Mehrere einzelne Kühlkammern können auch teilweise oder komplett in einer Abkühlstrecke realisiert werden, deren Länge über der Länge einzelner Kühlkammern liegt.

In einer bevorzugten Ausgestaltung der erfindungsgemäßen Vorrichtung enthalten die Strahlerfelder an sich bekannte Linearstrahler, insbesondere elektrisch betriebene stabförmige Infrarotstrahler und/oder eine Matrix aus an sich bekannten Punktstrahlquellen. Die Linearstrahler liegen bevorzugt parallel nebeneinander. Linearstrahler und Punktstrahlquellen sind dazu geeignet eine nahezu gleichmäßige flächige elektromagnetische Strahlung im Wärmestrahlungsbereich abzustrahlen.

In einer Ausgestaltung der erfindungemäßen Vorrichtung strahlt jedes Strahlerfeld eine elektromagnetische Strahlung gleicher Intensität nach beiden Seiten ab. In einer bevorzugten Ausgestaltung der erfindungsgemäßen Vorrichtung weisen die Strahlerfelder richtungsabhängige Abstrahlcharakteristika auf, insbesondere in Richtung der Prozessebenen. Dazu werden beispielsweise Linearstrahler verwendet, die eine einseitige reflektierende Beschichtung aufweisen, beispielsweise aus Keramik, Metall oder nanoporösem opaken Quarzglas, wie aus DE 10 2005 058819 A1 bekannt ist. Durch diese Maßnahme kann die Strahlungsintensität der Strahlerfelder im Hinblick auf eine Homogenisierung der Wärmeverteilung in den Mehrschichtkörpern in einfacher Weise gezielt verändert werden. Insbesondere können die Heizstrahler des zweiten Strahlerfelds jeweils über eine einseitigen Reflektor verfügen, so dass sie zur Bestrahlung der ersten Prozessebene oder der zweiten Prozessebene ausgebildet sind. Die Heizstrahler zur Bestrahlung der ersten oder zweiten Prozessebene sind beispielsweise in einer alternierenden Abfolge angeordnet.

Durch Strahlerfelder mit richtungsabhängiger Abstrahlcharakteristik können insbesondere verschiedene Seiten eines Mehrschichtkörpers mit unterschiedlichen Wärmeeinträgen geheizt werden. Entsprechendes gilt für Strahlerfelder mit unterschiedlicher Strahlungsleistung, was beispielsweise durch eine verschiedene Anzahl von Heizstrahlern in den Strahlerfeldern erreicht werden kann. Ebenso ist denkbar, die Heizstrahler verschiedener Strahlerfelder oder eines selben Strahlerfelds mit einer verschiedenen elektrischen Leistung zu beaufschlagen, um eine unterschiedliche Strahlungsintensität der Heizstrahler eines selben Strahlerfelds oder der Strahlungsintensität verschiedener Strahlerfelder für eine Homogenisierung der Wärmeverteilung in den Mehrschichtkörpern zu erzielen.

In einer weiteren bevorzugten Ausgestaltung der erfindungsgemäßen Vorrichtung umfasst das Strahlerfeld, das sich zwischen zwei Prozessebenen befindet, zwei beispielsweise untereinander angeordnete Ebenen von Linearstrahlern oder Punktstrahlquellen. Zwischen beiden Ebenen ist bevorzugt ein weiterer Reflektor angeordnet. Beide Ebenen können getrennt voneinander geheizt werden. Verschiedene Prozessebenen können so auf unterschiedliche Temperaturen geheizt werden.

In einer weiteren bevorzugten Ausführungsform enthält der zu prozessierende Mehrschichtkörper ein Glassubstrat mit einer Dicke von 1 mm bis 4 mm, bevorzugt von 2 mm bis 3 mm. Auf einer Substratseite ist eine Schichtfolge aus mehreren dünnen Schichten aufgebracht, beispielsweise Schichten der Abfolge Siliziumnitrid / Molybdän / Kupfer-Indium-Galium/Selen. Die Siliziumnitrid-Schichten haben Dicken von beispielsweise 50nm bis 300nm, die Molybdän-Schichten von beispielsweise 200 nm bis 700 nm, die Kupfer-Indium-Galium-Schichten von beispielsweise 300 nm bis 1000 nm und die Selen-Schichten von beispielsweise 500 nm bis 2000 nm.

Die Aufgabe der Erfindung wird des Weiteren durch ein Verfahren zum kontinuierlichen Wärmebehandeln von mindestens zwei Mehrschichtkörpern auf mindestens zwei Prozessebenen gelöst, wobei in einem ersten Schritt ein erster Mehrschichtkörper auf einer ersten Prozessebene und ein zweiter Mehrschichtkörper auf einer zweiten Prozessebene in mindestens eine Heizkammer eingefahren werden und mit Aufheizgeschwindigkeiten von 0°C bis 50 °C/s auf ein Temperaturniveau von 350 °C bis 800 °C, bevorzugt von 450°C bis 550°C, mittels Strahlerfeldern aufgeheizt werden, die beispielsweise oberhalb und/oder unterhalb der Prozessebenen angeordnet sind. Somit befindet sich die erste Prozessebene zwischen dem ersten Strahlerfeld und dem zweiten Strahlerfeld und die zweite Prozessebene zwischen dem zweiten Strahlerfeld und einem dritten Strahlerfeld. Vorteilhaft wird die erste und/oder zweite Prozessebene jeweils mit einer verschiedenen Strahlungsintensität so bestrahlt, dass eine homogene Wärmeverteilung in den Mehrschichtkörpern erzielt wird. Dementsprechend wird die erste Prozessebene durch das erste Strahlerfeld mit einer anderen Strahlungsintensität bestrahlt als durch das zweite Strahlerfeld und/oder die zweite Prozessebene durch das zweite Strahlerfeld mit einer anderen Strahlungsintensität bestrahlt als durch das dritte Strahlerfeld. Erfindungsgemäß weist die erste Prozessebene eine erste Prozessbox für wenigstens einen ersten Mehrschichtkörper und die zweite Prozessebene eine zweite Prozessbox für mindestens einen zweiten Mehrschichtkörper auf.

In einem zweiten Schritt werden der erste Mehrschichtkörper und der zweite Mehrschichtkörper in eine Kühlkammer gefahren und mit Abkühlgeschwindigkeiten von 0°C bis 50°C/s auf eine Temperatur von 10°C bis 350°C, bevorzugt auf eine Temperatur von 10°C bis 250°C und besonders bevorzugt auf eine Temperatur von 15°C bis 50°C, mittels Kühlplatten abgekühlt, die oberhalb und/oder unterhalb der Prozessebenen angeordnet sind. Alternativ kann die Abkühlung mittels Konvektions- und/oder Zwangskühlung erfolgen. Anschließend werden die Mehrschichtkörper aus der Kühlkammer herausgefahren.

Das erfindungsgemäße Verfahren wird in der oben genannten Vorrichtung zum Wärmebehandeln von mindestens zwei Mehrschichtkörpern ausgeführt.

In einer bevorzugten Ausführungsform des erfindungsgemäßen Verfahrens weisen beide Prozessebenen die gleiche Temperatur auf. In einer alternativen Ausführungsform des erfindungsgemäßen Verfahrens weisen beide Prozessebenen verschiedene Temperaturen auf, beispielsweise indem Strahlerfelder mit einer richtungsabhängigen Abstrahlcharakteristik verwendet werden.

In einer vorteilhaften Ausführungsform des erfindungsgemäßen Verfahrens erfolgt die Wärmebehandlung der Mehrschichtkörper in mindestens einer weiteren Heizkammer und/oder mindestens einer weiteren Kühlkammer, besonders bevorzugt in einer bis fünf weiteren Heizkammern und/oder einer bis fünf weiteren Kühlkammern. Dies ermöglicht ein präzises Steuern der Prozesse in den Mehrschichtkörpern. Insbesondere erfolgt in jeder Heiz- oder Kühlkammer eine Teilprozessierung des Mehrschichtkörpers bis zu einer bestimmten Prozessphase. Der Mehrschichtkörper ist dann beim Übergang von einer Kammer zur nächsten noch nicht vollständig prozessiert.

Eine bevorzugte Verwendung der erfindungsgemäßen Vorrichtung ist die Umwandlung von Vorläuferschichten in eine Halbleiterschicht. Die Halbleiterschicht wird vorzugsweise als Absorber in einer Dünnschichtsolarzelle verwendet.

Die Vorläuferschichten bestehen vorzugsweise aus Kupfer, Indium, Gallium und Selen und werden in einer schwefelhaltigen Atmosphäre durch Rapid Thermal Processing (RTP) in eine Cu(In,Ga)(S,Se)₂-Halbleiterschicht umgewandelt.

Im Folgenden wird die Erfindung anhand von Figuren und eines Flussdiagramms näher erläutert. Die Figuren zeigen rein schematische Darstellungen und sind nicht maßstabsgetreu. Die Figuren schränken die Erfindung in keiner Weise ein.

Es zeigen:
- Figur 1: einen Querschnitt durch die erfindungsgemäße Vorrichtung zur Wärmebehandlung zweier Mehrschichtkörper auf zwei untereinander angeordneten Prozessebenen,
- Figur 2: einen Querschnitt durch die Heizkammer der erfindungsgemäßen Vorrichtung,
- Figur 3: einen Querschnitt durch eine weitere Ausgestaltung der erfindungsgemäßen Heizkammer,
- Figur 4: einen Querschnitt durch eine weitere Ausgestaltung der erfindungsgemäßen Heizkammer,
- Figur 5: einen Querschnitt durch eine weitere Ausgestaltung der erfindungsgemäßen Heizkammer,
- Figur 6: einen Querschnitt durch eine weitere erfindungsgemäße Vorrichtung mit zwei Heizkammern und zwei Kühlkammern,
- Figur 7: ein Ausführungsbeispiel der erfindungsgemäßen Verfahrensschritte anhand eines Flussdiagramms.

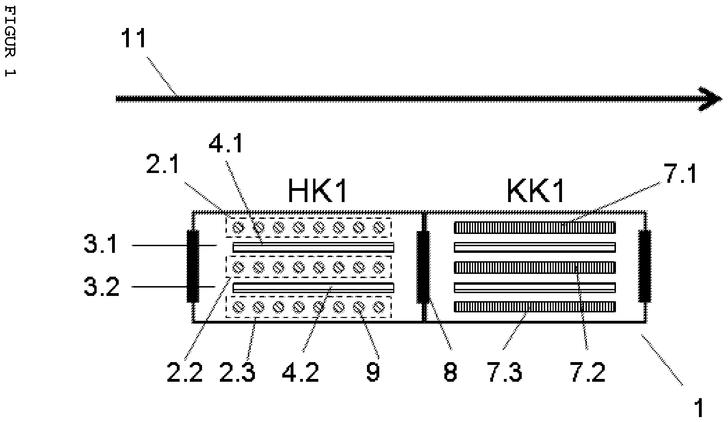

Figur 1 zeigt eine erfindungsgemäße Vorrichtung zur Wärmebehandlung von Mehrschichtkörpern am Beispiel einer In-Line-Anlage (1) zur Selenisierung von Vorläuferschichten durch Rapid Thermal Processing (RTP). Die In-Line-Anlage (1) weist eine Heizkammer (HK1) und eine Kühlkammer (KK1) auf, die in Transportrichtung (11) hintereinander angeordnet sind. Die In-Line-Anlage (1) weist zwei Prozessebenen (3.1) und (3.2) auf, die vertikal übereinander angeordnet sind. Ein horizontaler Aufbau ist erfindungsgemäß ebenfalls vorgesehen. In der Heizkammer (HK1) ist über der oberen Prozessebene (3.1) ein Strahlerfeld (2.1) und unterhalb der unteren Prozessebene (3.2) ein Strahlerfeld (2.3) angeordnet. Außerdem ist ein Strahlerfeld (2.2) zwischen den Prozessebenen (3.1) und (3.2) angeordnet.

In der Kühlkammer (KK1) ist über der oberen Prozessebene (3.1) eine Kühlplatte (7.1) und unterhalb der unteren Prozessebene (3.2) eine Kühlplatte (7.3) angeordnet. Außerdem ist eine Kühlplatte (7.2) zwischen den Prozessebenen (3.1) und (3.2) angeordnet. Die Kühlplatten (7.1, 7.2, 7.3) enthalten beispielsweise Edelstahl und weisen in ihrem Innern ein Verteilsystem für das Wärmeträgermedium auf. Das Verteilsystem wird beispielsweise mit Öl oder Wasser als Wärmeträgermedium durchflossen. Das Wärmeträgermedium wird außerhalb der In-Line-Anlage (1) in einem Kühlaggregat gekühlt.

Die Heizkammer (HK1) und die Kühlkammer (KK1) sind vakuum- und gasdicht ausgestaltet und mit Vakuumpumpen und einer Vorrichtung zur Gasversorgung verbunden. Die Heizkammer (HK1) und die Kühlkammer (KK1) sind durch eine Schleuse (8) voneinander getrennt.

Die Mehrschichtkörper (4.1) und (4.2) befinden sich auf den Prozessebenen (3.1) und (3.2). Die Mehrschichtkörper (4.1) und (4.2) enthalten beispielsweise ein Glassubstrat mit einer Molybdän-Elektrode und eine Stapelfolge von Vorläuferschichten, die Kupfer, Indium, Gallium, Schwefel und Selen enthalten.

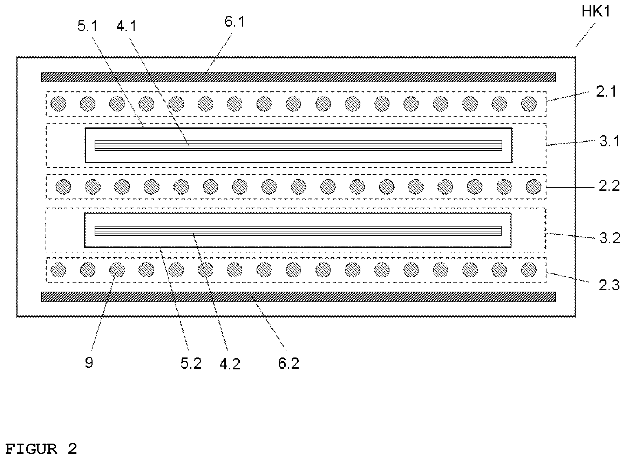

Figur 2 zeigt eine schematische Darstellung einer beispielhaften Ausgestaltung der Heizkammer (HK1) einer erfindungsgemäßen Vorrichtung. Die Mehrschichtkörper (4.1) und (4.2) sind jeweils in Prozessboxen (5.1) und (5.2) angeordnet. Die Prozessboxen (5.1, 5.2) enthalten einen Boden und einen Deckel aus Glaskeramik und Seitenwände aus Graphit. Die Glaskeramik ist durchlässig für die elektromagnetische Strahlung der Strahlerfelder (2.1, 2.2, 2.3). Die Prozessboxen (5.1, 5.2) sind teilweise gasdicht ausgeführt, so dass ein Druckausgleich zwischen dem Innern der Prozessboxen (5.1, 5.2) und der Atmosphäre der Heizkammer (HK1) erfolgen kann. Teilweise gasdicht bedeutet, dass der Deckel lose auf die Seitenwände aufgelegt wird und keine weiteren Maßnahmen zur Abdichtung erfolgt sind. Die Prozessboxen (5.1, 5.2) können auch Anschlussstößel aufweisen. Über die Anschlussstößel kann den Prozessboxen (5.1, 5.2) gezielt ein Prozess- oder Inertgas zugeführt werden.

Der Transport der Prozessboxen (5.1, 5.2) erfolgt durch ein System aus Stummelrollen. Die Stummelrollen stützen die Prozessboxen (5.1, 5.2) unter ihrem längsseitigen Außenrand. Die Stummelrollen enthalten beispielsweise eine hochtemperaturbeständige Keramik. Die Transportgeschwindigkeit zwischen zwei benachbarten Kammern beträgt typischerweise bis zu 1 m/s.

Über dem ersten Strahlerfeld (2.1) und unter dem dritten Strahlerfeld (2.3) sind ein erster Reflektor (6.1) und ein zweiter Reflektor (6.2) angeordnet. Der erste Reflektor (6.1) reflektiert die nach oben gerichtete elektromagnetische Strahlung des ersten Strahlerfeldes (2.1) in Richtung der ersten Prozessebene (3.1). Der zweite Reflektor (6.2) reflektiert die nach unten gerichtete elektromagnetische Strahlung des dritten Strahlerfeldes (2.3) in Richtung der zweiten Prozessebene (3.2).

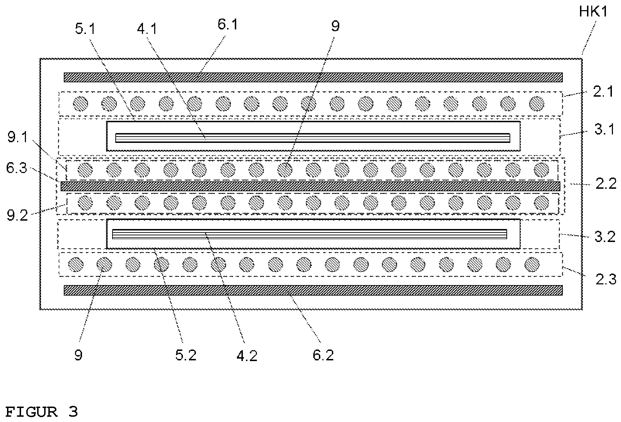

Figur 3 zeigt eine weitere Ausgestaltung einer erfindungsgemäßen Heizkammer (HK1). Das zweite Strahlerfeld (2.2) besteht aus zwei Ebenen (9.1) und (9.2) von Linearstrahlern (9), die durch einen Reflektor (6.3) voneinander getrennt sind. Durch eine unterschiedliche Anzahl von Linearstrahlern (9) in Ebene (9.1) im Vergleich zu Ebene (9.2), durch eine unterschiedliche Beschaltung der Linearstrahler (9) in den Ebenen (9.1) und (9.2) und/oder durch eine unterschiedliche zeitabhängige Leistungsregelung in den Ebenen (9.1) und (9.2) wird eine richtungsabhängige Abstrahlungscharakteristik des zweiten Strahlerfeldes (2.2) erzielt.

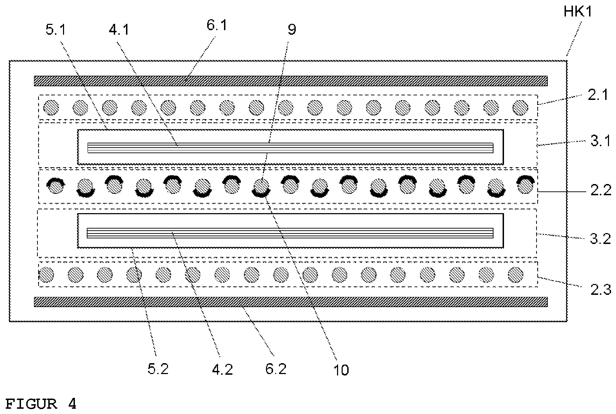

Figur 4 zeigt eine weitere bevorzugte Ausgestaltung einer erfindungsgemäßen Heizkammer (HK1). Die Linearstrahler (9) des zweiten Strahlerfeldes (2.2) sind abwechselnd an ihrer Oberseite und ihrer Unterseite mit einer Reflektorschicht (10) beschichtet. Die Reflektorschicht (10) kann eine opake nanoporöse Quarzschicht enthalten, die direkt auf den Linearstrahlern (9) aufgebracht ist. Alternativ kann die Reflektorschicht (10) eine Halbschale aus Keramik enthalten. Die Linearstrahler (9) mit einer Reflektorschicht (10) auf der Oberseite und die Linearstrahler (9) mit einer Reflektorschicht (10) auf der Unterseite können auf unterschiedliche Temperaturen geheizt werden.

Durch unterschiedliche Strahlungsleistungen und richtungsabhängige Abstrahlungscharakteristika der Strahlerfelder (2.1, 2.2, 2.3) können verschiedene Seiten eines Mehrschichtkörpers (4.1, 4.2) auf unterschiedliche Temperaturen geheizt werden. So kann beispielsweise eine Substratseite eines Mehrschichtkörpers (4.1, 4.2) auf eine niedrigere Temperatur geheizt werden als eine Seite mit Vorläuferschichten, die in eine Halbleiterschicht umgewandelt werden sollen.

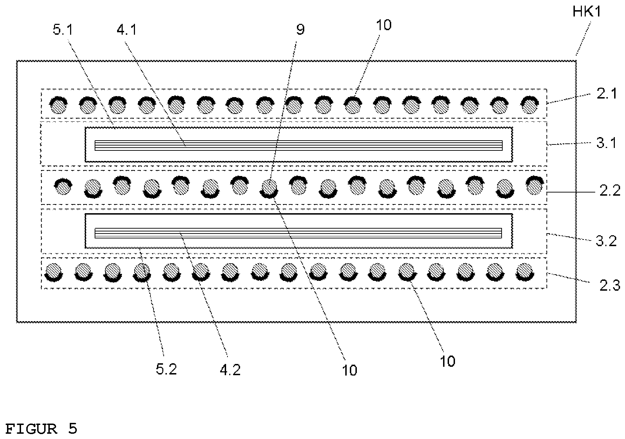

Figur 5 zeigt eine weitere bevorzugte Ausgestaltung einer erfindungsgemäßen Heizkammer (HK1). Die Linearstrahler (9) des ersten Strahlerfeldes (2.1) sind auf der Oberseite und die Linearstrahler (9) des dritten Strahlerfeldes (2.3) auf der Unterseite mit einer Reflektorschicht (10) beschichtet. Durch die richtungsabhängige Abstrahlcharakteristik des ersten Strahlerfeldes (2.1) und des dritten Strahlerfeldes (2.3) kann auf zusätzliche Reflektoren verzichtet werden. Der Einsatz zusätzlicher Reflektoren über dem ersten Strahlerfeld (2.1) und unter dem Strahlerfeld (2.3) kann den Wirkungsgrad der richtungsabhängigen Abstrahlcharakteristik erhöhen.

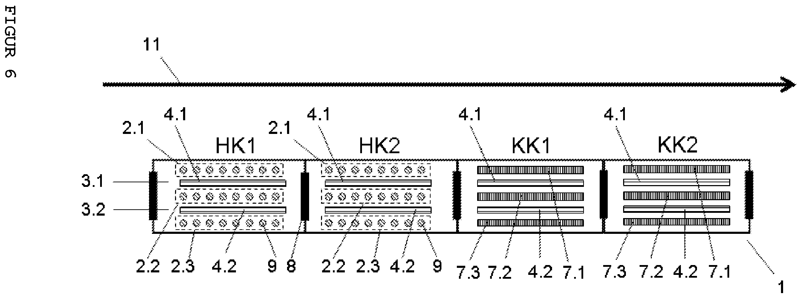

Figur 6 zeigt eine weitere vorteilhafte Ausgestaltung einer erfindungsgemäßen Vorrichtung mit zwei Heizkammern (HK1) und (HK2) und zwei Kühlkammern (KK1) und (KK2). Die Mehrschichtkörper (4.1) und (4.2) durchlaufen in Transportrichtung (11) die Heizkammern (HK1) und (HK2) und die Kühlkammern (KK1) und (KK2). Die Heizkammern (HK1) und (HK2) und die Kühlkammern (KK1) und (KK2) können unterschiedliche Heiz- und Kühlleistungen sowie unterschiedliche Temperaturenprofile aufweisen. Dies ermöglicht eine besonders genaue Prozesskontrolle. So kann beispielsweise die erste Heizkammer (HK1) eine höhere Heizleistung aufweisen als die zweite Heizkammer (HK2). In den Heizkammern (HK1) und (HK2) sowie den Kühlkammern (KK1) und (KK2) werden die Mehrschichtkörper (4.1) und (4.2) einem gewünschten Temperaturverlauf und einer gewünschten Prozessgasatmosphäre ausgesetzt. Verschiedene Heiz- und Kühlkammern können unterschiedliche Prozessatmosphären aufweisen. In einer weiteren Ausgestaltung der erfindungsgemäßen Vorrichtung können weitere Heiz- und Kühlkammern hintereinander angeordnet werden. Wenn es die Prozessführung erfordert, können die Heiz- und Kühlkammern alternierend angeordnet werden, das heißt auf eine Kühlkammer kann beispielsweise wiederum eine Heizkammer folgen.

In den Ausführungsbeispielen sind das erste Strahlerfeld (2.1) und das zweite Strahlerfeld (2.2) so ausgebildet, dass die Oberseite des oberen Mehrschichtkörpers (4.1) durch das erste Strahlerfeld (2.1) mit einer Strahlungsintensität geheizt werden kann, welche verschieden ist von einer Strahlungsintensität, mit der die Unterseite des oberen Mehrschichtkörpers (4.1) durch das zweite Strahlerfeld (2.2) geheizt werden kann. In entsprechender Weise sind das zweite Strahlerfeld (2.2) und das dritte Strahlerfeld (2.3) so ausgebildet, dass die Oberseite des unteren Mehrschichtkörpers (4.2) durch das zweite Strahlerfeld (2.2) mit einer Strahlungsintensität geheizt werden kann, die verschieden ist von einer Strahlungsintensität, mit der die Unterseite des unteren Mehrschichtkörpers (4.2) durch das dritte Strahlerfeld (2.3) geheizt werden kann. Auf diese Weise kann eine homogene Wärmeverteilung in jedem der beiden Mehrschichtkörper (4.1) und (4.2) erreicht werden.

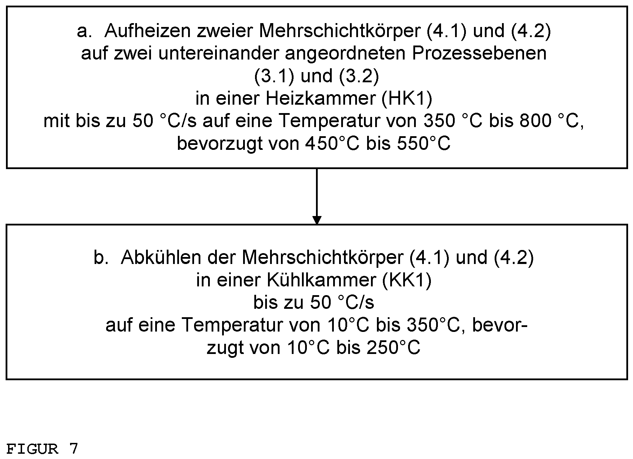

Figur 7 zeigt ein Ausführungsbeispiel der erfindungsgemäßen Verfahrensschritte anhand eines Flussdiagramms. Zunächst wird in einer Ladestation der Mehrschichtkörper (4.1) in eine Prozessbox (5.1) und der Mehrschichtkörper (4.2) in eine Prozessbox (5.2) eingesetzt. Anschließend werden die Prozessboxen (5.1) und (5.2) in eine Einschleusekammer geladen und die Einschleusekammer geschlossen. In der Einschleusekammer wird durch mehrmaliges Evakuieren und Fluten mit Inertgas eine definierte und gewünschte Prozessgasatmosphäre eingestellt. Anschließend wird im Verfahrensschritt (a) die Prozessbox (5.1) mit dem Mehrschichtkörper (4.1) in die Prozessebene (3.1) und die Prozessbox (5.2) mit dem Mehrschichtkörper (4.2) in die Prozessebene (3.2) gefahren.

In den Heizkammern (HK1) und (HK2) wird das gewünschte Heizprofil (Temperatur und Prozessgasatmosphäre in Abhängigkeit von der Prozesszeit) gefahren: In der Heizkammer (HK1) wird der erste Mehrschichtkörper (4.1) auf einer ersten Prozessebene (3.1) und der zweite Mehrschichtkörper (4.2) auf einer zweiten Prozessebene (3.2) mit den Strahlerfeldern (2.1, 2.2, 2.3) aufgeheizt, die oberhalb und/oder unterhalb der Prozessebenen (3.1, 3.2) angeordnet sind. Vorzugsweise werden die beiden Mehrschichtkörper (4.1) und (4.2) mit einer Aufheizgeschwindigkeit von 1 °C/s bis 50 °C/s auf eine Temperatur von 350 °C bis 800 °C mittels der Strahlerfelder (2.1, 2.2, 2.3) aufgeheizt. Die Mehrschichtkörper (4.1) und (4.2) werden jeweils auf ihrer Ober- und Unterseite mit einer verschiedenen Bestrahlungsintensität geheizt, um eine homogene Wärmeverteilung in jedem Mehrschichtkörper zu erzielen. Anschließend werden im Verfahrensschritt (b) die Mehrschichtkörper (4.1) und (4.2) in eine Kühlkammer (KK1) gefahren. Gleichzeitig können neue Mehrschichtkörper in die Heizkammer (HK1) eingefahren werden. In den Kühlkammern (KK1) und (KK2) werden die heißen Mehrschichtkörper (4.1) und (4.2) mit bis zu 50°C/s bis zu einer prozesstechnisch notwendigen Temperatur abgekühlt. Vorzugsweise werden die beiden Mehrschichtkörper (4.1) und (4.2) mit einer Abkühlgeschwindigkeit von 0°C/s bis 50°C/s auf eine Temperatur von 10°C bis 350°C abgekühlt. Aufgrund der geringer werdenden Temperaturdifferenz zwischen der Temperatur der Mehrschichtkörper (4.1) und (4.2) und der Temperatur der Kühlplatten (7.1, 7.2, 7.3) verlangsamt sich die Geschwindigkeit des Abkühlens der Mehrschichtkörper (4.1) und (4.2). Dem kann durch geeignete Maßnahmen entgegengewirkt werden, wie der Verringerung des Abstandes zwischen den Kühlplatten und den Mehrschichtkörpern, beispielsweise durch Verfahren des Abstandes als Funktion der Zeit, oder der Anpassung der Temperatur der Kühlplatten. Der Abkühlungsprozess kann zusätzlich durch einen zirkulierenden gekühlten Gasstrom beschleunigt werden, beispielsweise ein Luft-, Argon- oder Stickstoffstrom. Alternativ ist eine Abkühlung durch Konvektions- oder Zwangskühlung ohne Kühlplatten realisierbar.

Anschließend werden die Mehrschichtkörper (4.1) und (4.2) aus der Kühlkammer (KK1) in eine Ausschleusekammer gefahren und einer weiteren Verarbeitung zugeführt. In der Ausschleusekammer können beispielsweise vorhandene toxische Gase entfernt werden. Es ist auch möglich, nach der Ausschleusekammer eine weitere Kühlstrecke oder weitere Kühlkammern anzuordnen. Auf die Ausschleusekammer kann in bestimmten Ausführungsformen verzichtet werden.

Wie aus Tabelle 1 am Beispiel einer In-Line-Selenisierungsanlage zur Herstellung von Chalkopyrit-Halbleitern hervorgeht, bietet die erfindungsgemäße Vorrichtung Vorteile im Vergleich zum Stand der Technik.

**Tabelle 1: Potentialabschätzung der Erfindung**

| | In-Line-Selenisierungsanlage mit einer Prozessebene nach Stand der Technik | Erfindungsgemäße In-Line-Selenisierungsanlage mit zwei Prozessebenen |
|---|---|---|
| Größe der Standfläche | 100% | 100% |
| Investitionskosten | 100% | 130% |
| Anlagendurchsatz | 100% | 200% |
| Energiekosten pro Mehrschichtkörper | 100% | 70% |

Eine erfindungsgemäße Vorrichtung mit zwei vertikal angeordneten Prozessebenen bietet bei nahezu gleicher Standfläche der Anlage und nur geringfügig höheren Investitionskosten einen doppelten Anlagendurchsatz verglichen mit In-Line-Selenisierungsanlagen nach dem Stand der Technik mit einer Prozessebene. Trotz des verdoppelten Anlagendurchsatzes ist der für die Anlage notwendige Flächenbedarf nicht oder nur unwesentlich erhöht, was positive Auswirkungen auf die Gesamtinvestition und Betriebskosten einer Solarfabrik hat.

Die Energiekosten pro Mehrschichtkörper sind bei erfindungsgemäßen Vorrichtungen bis zu etwa 30% reduziert. Dies erfolgt insbesondere durch die effektive Nutzung der abgestrahlten Wärmeenergie des zweiten Strahlerfeldes.

Dieses Ergebnis war für den Fachmann unerwartet und überraschend.

### Bezugszeichenliste

- (1): In-Line-Anlage
- (2.1), (2.2), (2.3): Strahlerfeld
- (3.1), (3.2): Prozessebene
- (4.1), (4.2): Mehrschichtköper
- (5.1), (5.2): Prozessbox
- (6.1), (6.2), (6.3): Reflektor
- (7.1),(7.2),(7.3): Kühlplatte
- (8): Schleuse
- (9): Heizstrahler, Linearstrahler
- (9.1), (9.2): Ebene von Heizstrahlern (9)
- (10): Reflektorschicht für Heizstrahler (9)
- (11): Transportrichtung

## Patentansprüche

1. Vorrichtung zum Wärmebehandeln von mindestens zwei Mehrschichtkörpern (4.1, 4.2) auf mindestens zwei untereinander angeordneten Prozessebenen (3.1, 3.2) in mindestens einer Heizkammer (HK1) und mindestens einer Kühlkammer (KK1), die bezüglich der Transportrichtung (11) hintereinander angeordnet sind, wobei die Heizkammer (HK1) umfasst
- eine erste Prozessebene (3.1) mit einer ersten Prozessbox (5.1) für wenigstens einen ersten Mehrschichtkörper (4.1), welche sich zwischen einem ersten Strahlerfeld (2.1) und einem zweiten Strahlerfeld (2.2) mit Heizstrahlern (9) zum Beheizen des ersten Mehrschichtkörpers (4.1) befindet,
- eine zweite Prozessebene (3.2) mit einer zweiten Prozessbox (5.2) für wenigstens einen zweiten Mehrschichtkörper (4.2), welche sich zwischen dem zweiten Strahlerfeld (2.2) und einem dritten Strahlerfeld (2.3) mit Heizstrahlern (9) zum Beheizen des zweiten Mehrschichtkörpers (4.2) befindet,
wobei das erste Strahlerfeld (2.1) und das zweite Strahlerfeld (2.2) so ausgebildet sind, dass die erste Prozessebene (3.1) durch das erste Strahlerfeld (2.1) mit einer anderen Strahlungsintensität bestrahlt werden kann als durch das zweite Strahlerfeld (2.2) und/oder wobei das zweite Strahlerfeld (2.2) und das dritte Strahlerfeld (2.3) so ausgebildet sind, dass die zweite Prozessebene (3.2) durch das zweite Strahlerfeld (2.2) mit einer anderen Strahlungsintensität bestrahlt werden kann als durch das dritte Strahlerfeld (2.3), und wobei
die Kühlkammer (KK1) umfasst
- eine Kühlvorrichtung
- die erste Prozessebene (3.1) zum Kühlen des zumindest einen ersten Mehrschichtkörpers (4.1) und die zweite Prozessebene (3.2) zum Kühlen des zumindest einen zweiten Mehrschichtkörpers (4.2).

2. Vorrichtung nach Anspruch 1, wobei die Strahlerfelder (2.1, 2.2, 2.3) eine richtungsabhängige Abstrahlcharakteristik für elektromagnetische Strahlung und/oder eine unterschiedliche Strahlungsleistung aufweisen.

3. Vorrichtung nach Anspruch 2, wobei die Heizstrahler (9) eine Reflektorschicht (10) aufweisen.

4. Vorrichtung nach Anspruch 3, wobei die Heizstrahler (9) des zwischen den beiden Prozessebenen (3.1, 3.2) angeordneten zweiten Strahlerfelds (2.2) eine Reflektorschicht (10) aufweisen und dazu ausgebildet sind, entweder die erste Prozessebene (3.1) oder die zweite Prozessebene (3.2) zu bestrahlen.

5. Vorrichtung nach Anspruch 1, wobei das zwischen den beiden Prozessebenen (3.1, 3.2) angeordnete zweite Strahlerfeld (2.2) zwei Heizstrahlerebenen (9.1, 9.2) mit Heizstrahlern (9) aufweist, wobei die eine Heizstrahlerebene (9.1) dazu ausgebildet ist, die erste Prozessebene (3.1) zu bestrahlen, und die andere Heizstrahlerebene (9.2) dazu ausgebildet ist, die zweite Prozessebene (3.2) zu bestrahlen.

6. Vorrichtung nach Anspruch 5, wobei zwischen den beiden Heizstrahlerebenen (9.1, 9.2) ein Reflektor (6.3) angeordnet ist.

7. Vorrichtung nach einem der Ansprüche 1 bis 6, wobei die Heizstrahler (9) zur Erzeugung einer veränderlichen Strahlungsintensität selektiv ansteuerbar sind.

8. Vorrichtung nach einem der Ansprüche 1 bis 7, wobei die Strahlerfelder (2.1, 2.2, 2.3) und die Prozessebenen (3.1, 3.2) parallel zueinander angeordnet sind.

9. Vorrichtung nach einem der Ansprüche 1 bis 8, wobei die Kühlvorrichtung eine erste Kühlplatte (7.1), eine zweite Kühlplatte (7.2) und eine dritte Kühlplatte (7.3) zum Kühlen der Mehrschichtkörper (4.1, 4.2) umfasst, wobei sich die erste Prozessebene (3.1) zwischen der ersten Kühlplatte (7.1) und der zweiten Kühlplatte (7.2) und die zweite Prozessebene (3.2) zwischen der zweiten Kühlplatte (7.2) und der dritten Kühlplatte (7.3) befindet.

10. Vorrichtung nach einem der Ansprüche 1 bis 9, wobei die Kühlvorrichtung einen geführten Gasstrom aufweist.

11. Vorrichtung nach einem der Ansprüche 1 bis 10, wobei zwischen der Heizkammer (HK1) und der Kühlkammer (KK1) eine Schleuse (8) oder ein Schieber angeordnet ist.

12. Vorrichtung nach einem der Ansprüche 1 bis 11, wobei in der Heizkammer (HK1) und/oder in der Kühlkammer (KK1) mindestens zwei Mehrschichtkörper (4.1, 4.2) auf einer Prozessebene (3.1, 3.2) in Transportrichtung nebeneinander angeordnet sind.

13. Vorrichtung nach einem der Ansprüche 1 bis 12, wobei die Heizkammer (HKI) mindestens einen ersten Reflektor (6.1) und mindestens einen zweiten Reflektor (6.2) umfasst, wobei das erste Strahlerfeld (2.1) zwischen dem ersten Reflektor (6.1) und der ersten Prozessebene (3.1) angeordnet ist und der erste Reflektor (6.1) dazu ausgebildet ist, elektromagnetische Strahlung des ersten Strahlerfelds (2.1) zu reflektieren, und wobei das dritte Strahlerfeld (2.3) zwischen dem zweiten Reflektor (6.2) und der zweiten Prozessebene (3.2) angeordnet ist und der zweite Reflektor (6.2) dazu ausgebildet ist, elektromagnetische Strahlung des dritten Strahlerfelds (2.3) zu reflektieren.

14. Vorrichtung nach einem der Ansprüche 1 bis 13, wobei die Heizkammer (HK1) und/oder die Kühlkammer (KK1) eine Einrichtung zur Erzeugung eines Vakuums und/oder einer Gasatmosphäre, die bevorzugt ein Prozessgas oder ein Inertgas enthält, aufweisen.

15. Verfahren zum kontinuierlichen Wärmebehandeln von mindestens zwei Mehrschichtkörpern (4.1, 4.2) auf mindestens zwei Prozessebenen (3.1, 3.2), wobei:
a. die Mehrschichtkörper (4.1) und (4.2) in mindestens einer Heizkammer (HK1) mit einer Aufheizgeschwindigkeit von 1 °C/s bis 50 °C/s auf eine Temperatur von 350 °C bis 800 °C mittels Strahlerfelder (2.1, 2.2, 2.3) aufgeheizt werden, wobei sich eine erste Prozessebene (3.1) mit einer ersten Prozessbox (5.1) für wenigstens einen ersten Mehrschichtkörper (4.1) zwischen einem ersten Strahlerfeld (2.1) und einem zweiten Strahlerfeld (2.2) und eine zweite Prozessebene (3.2) mit einer zweiten Prozessbox (5.2) für wenigstens einen zweiten Mehrschichtkörper (4.2) zwischen dem zweiten Strahlerfeld (2.2) und einem dritten Strahlerfeld (2.3) befindet, wobei die erste Prozessebene
(3.1) durch das erste Strahlerfeld (2.1) mit einer anderen Strahlungsintensität bestrahlt wird als durch das zweite Strahlerfeld (2.2) und/oder wobei die zweite Prozessebene (3.2) durch das zweite Strahlerfeld (2.2) mit einer anderen Strahlungsintensität bestrahlt wird als durch das dritte Strahlerfeld (2.3), und
b. die Mehrschichtkörper (4.1) und (4.2) in mindestens einer Kühlkammer (KK1) mit einer Abkühlgeschwindigkeit von 0°C/s bis 50°C/s auf eine Temperatur von 10°C bis 350°C abgekühlt werden.

## Claims

1. Device for heat-treating at least two multilayer bodies (4.1, 4.2) on at least two process levels (3.1, 3.2) disposed one beneath another in at least one heating chamber (HK1) and at least one cooling chamber (KK1), which are disposed one behind another relative to the transport direction (11), wherein the heating chamber (HK1) comprises
- a first process level (3.1) with a first process box (5.1) for at least one first multilayer body (4.1), which is situated between a first radiator field (2.1) and a second radiator field (2.2) with radiant heaters (9) for heating the first multilayer body (4.1),
- a second process level (3.2) with a second process box (5.2) for at least one second multilayer body (4.2), which is situated between the second radiator field (2.2) and a third radiator field (2.3) with radiant heaters (9) for heating the second multilayer body (4.2),
wherein the first radiator field (2.1) and the second radiator field (2.2) are implemented such that the first process level (3.1) can be irradiated by the first radiator field (2.1) with a different radiation intensity than by the second radiator field (2.2) and/or wherein the second radiator field (2.2) and the third radiator field (2.3) are implemented such that the second process level (3.2) can be irradiated by the second radiator field (2.2) with a different radiation intensity than by the third radiator field (2.3), and wherein
the cooling chamber (KK1) comprises
- a cooling device
- the first process level (3.1) for cooling the at least one first multilayer body (4.1) and the second process level (3.2) for cooling the at least one second multilayer body (4.2).

2. Device according to claim 1, wherein the radiator fields (2.1, 2.2, 2.3) have a direction-dependent radiation characteristic for electromagnetic radiation and/or a different radiant power.

3. Device according to claim 2, wherein the radiant heaters (9) have a reflector layer (10).

4. Device according to claim 3, wherein the radiant heaters (9) of the second radiator field (2.2) disposed between the two process levels (3.1, 3.2) have a reflector layer (10) and are implemented to irradiate either the first process level (3.1) or the second process level (3.2).

5. Device according to claim 1, wherein the second radiator field (2.2) disposed between the two process levels (3.1, 3.2) has two radiant heater levels (9.1, 9.2) with radiant heaters (9), wherein one radiant heater level (9.1) is implemented to irradiate the first process level (3.1), and the other radiant heater level (9.2) is implemented to irradiate the second process level (3.2).

6. Device according to claim 5, wherein a reflector (6.3) is disposed between the two radiant heater levels (9.1, 9.2).

7. Device according to one of claims 1 through 6, wherein the radiant heaters (9) can be selectively controlled to generate a variable radiation intensity.

8. Device according to one of claims 1 through 7, wherein the radiator fields (2.1, 2.2, 2.3) and the process levels (3.1, 3.2) are disposed parallel to each other.

9. Device according to one of claims 1 through 8, wherein the cooling device comprises a first cooling plate (7.1), a second cooling plate (7.2), and a third cooling plate (7.3) for cooling the multilayer bodies (4.1, 4.2), wherein the first process level (3.1) is situated between the first cooling plate (7.1) and the second cooling plate (7.2), and the second process level (3.2) is situated between the second cooling plate (7.2) and the third cooling plate (7.3).

10. Device according to one of claims 1 through 9, wherein the cooling device has a guided gas stream.

11. Device according to one of claims 1 through 10, wherein an air lock (8) or a slide gate is disposed between the heating chamber (HK1) and the cooling chamber (KK1).

12. Device according to one of claims 1 through 11, wherein at least two multilayer bodies (4.1, 4.2) are disposed on one process level (3.1, 3.2) next to each other in the transport direction in the heating chamber (HK1) and/or in the cooling chamber (KK1).

13. Device according to one of claims 1 through 12, wherein the heating chamber (HK1) comprises at least one first reflector (6.1) and at least one second reflector (6.2), wherein the first radiator field (2.1) is disposed between the first reflector (6.1) and the first process level (3.1), and the first reflector (6.1) is implemented to reflect electromagnetic radiation of the first radiator field (2.1), and wherein the third radiator field (2.3) is disposed between the second reflector (6.2) and the second process level (3.2), and the second reflector (6.2) is implemented to reflect electromagnetic radiation of the third radiator field (2.3).

14. Device according to one of claims 1 through 13, wherein the heating chamber (HK1) and/or the cooling chamber (KK1) has a device for generating a vacuum and/or a gas atmosphere that preferably contains a process gas or an inert gas.

15. Method for the continuous heat-treatment of at least two multilayer bodies (4.1, 4.2) on at least two process levels (3.1, 3.2), wherein:
a. the multilayer bodies (4.1) and (4.2) are heated in at least one heating chamber (HK1) with a heating rate of 1 °C/s to 50 °C/s to a temperature of 350 °C to 800 °C using radiator fields (2.1, 2.2, 2.3), wherein a first process level (3.1) with a first process box (5.1) for at least one first multilayer body (4.1) is situated between a first radiator field (2.1) and a second radiator field (2.2), and a second process level (3.2) with a second process box (5.2) for at least one second multilayer body (4.2) is situated between the second radiator field (2.2) and a third radiator field (2.3), wherein the first process level (3.1) is irradiated by the first radiator field (2.1) with a different radiation intensity than by the second radiator field (2.2), and/or wherein the second process level (3.2) is irradiated by the second radiator field (2.2) with a different radiation intensity than by the third radiator field (2.3), and
b. the multilayer bodies (4.1) and (4.2) are cooled in at least one cooling chamber (KK1) with a cooling rate of 0 °C/s to 50 °C/s to a temperature of 10 °C to 350 °C.

## Revendications

1. Dispositif pour le traitement thermique d'au moins deux corps multicouches (4.1, 4.2) sur au moins deux niveaux de processus (3.1, 3.2) disposés l'un au-dessous de l'autre dans au moins une chambre de chauffage (HK1) et au moins une chambre de refroidissement (KK1), qui sont disposées l'une derrière l'autre par rapport au sens de transport (11), où la chambre de chauffage (HK1) comprend
- un premier niveau de processus (3.1) avec un premier boîtier de traitement (5.1) pour au moins un premier corps multicouche (4.1), qui est situé entre un premier champ de radiation (2.1) et un deuxième champ de radiation (2.2) avec des radiateurs de chauffage (9) pour chauffer le premier corps multicouche (4.1),
- un deuxième niveau de processus (3.2) avec un deuxième boîtier de traitement (5.2) pour au moins un deuxième corps multicouche (4.2), qui est situé entre le deuxième champ de radiation (2.2) et un troisième champ de radiation (2.3) avec des radiateurs chauffants (9) pour chauffer le deuxième corps multicouche (4.2),
où le premier champ de radiation (2.1) et le deuxième champ de radiation (2.2) sont conçus de telle manière que le premier niveau de processus (3.1) peut être irradié par le premier champ de radiation (2.1) avec une intensité de radiation différente de celle du deuxième champ de radiation (2.2) et/ou le deuxième champ de radiation (2.2) et le troisième champ de radiation (2.3) sont conçus de telle manière que le deuxième niveau de processus (3.2) peut être irradié par le deuxième champ de radiation (2.2) avec une intensité de radiation différente de celle du troisième champ de radiation (2.3), et où
la chambre de refroidissement (KK1) comprend
- un dispositif de refroidissement
- le premier niveau de processus (3.1) pour le refroidissement d'au moins un premier corps multicouche (4.1) et le deuxième niveau de processus (3.2) pour le refroidissement d'au moins un second corps multicouche (4.2).

2. Dispositif selon la revendication 1, où les champs de radiation (2.1, 2.2, 2.3) présentent une caractéristique de radiation dépendant de la direction pour la radiation électromagnétique et/ou une puissance de radiation différente.

3. Dispositif selon la revendication 2, où les radiateurs de chauffage (9) présentent une couche réfléchissante (10).

4. Dispositif selon la revendication 3, où les radiateurs chauffants (9) du deuxième champ de radiation (2.2) disposés entre les deux niveaux de processus (3.1, 3.2) présentent une couche réfléchissante (10) et sont conçus pour irradier soit le premier niveau de processus (3.1), soit le deuxième niveau de processus (3.2).

5. Dispositif selon la revendication 1, où le champ de radiation (2.2) disposé entre les deux niveaux de processus (3.1, 3.2) comporte deux niveaux de chauffage par radiation (9.1, 9.2) avec des radiateurs de chauffage (9), où un niveau de chauffage par radiation (9.1) est conçu pour irradier le premier niveau de processus (3.1) et l'autre niveau de chauffage par radiation (9.2) est conçu pour irradier le deuxième niveau de processus (3.2).

6. Dispositif selon la revendication 5, où un réflecteur (6.3) est disposé entre les deux niveaux de chauffage par radiation (9.1, 9.2).

7. Dispositif selon l'une des revendications 1 à 6, où les radiateurs de chauffage (9) peuvent être commandés de manière sélective pour générer une intensité de radiation variable.

8. Dispositif selon l'une des revendications 1 à 7, où les champs de radiation (2.1, 2.2, 2.3) et les niveaux de processus (3.1, 3.2) sont disposés parallèlement les uns aux autres.

9. Dispositif selon l'une des revendications 1 à 8, où le dispositif de refroidissement comprend une première plaque de refroidissement (7.1), une deuxième plaque de refroidissement (7.2) et une troisième plaque de refroidissement (7.3) pour refroidir les corps multicouches (4.1, 4.2), où le premier niveau de processus (3.1) est situé entre la première plaque de refroidissement (7.1) et la deuxième plaque de refroidissement (7.2) et le deuxième niveau de processus (3.2) est situé entre la deuxième plaque de refroidissement (7.2) et la troisième plaque de refroidissement (7.3).

10. Dispositif selon l'une des revendications 1 à 9, où le dispositif de refroidissement présente un flux de gaz guidé.

11. Dispositif selon l'une des revendications 1 à 10, où entre la chambre de chauffage (HK1) et la chambre de refroidissement (KK1) est disposé un sas (8) ou un poussoir.

12. Dispositif selon l'une des revendications 1 à 11, où au moins deux corps multicouches (4.1, 4.2) sont disposés dans la chambre de chauffage (HK1) et/ou dans la chambre de refroidissement (KK1) à un niveau de processus (3.1, 3.2) l'un à côté de l'autre dans le sens du transport.

13. Dispositif selon l'une des revendications 1 à 12, où la chambre de chauffage (HKI) comprend au moins un premier réflecteur (6.1) et au moins un deuxième réflecteur (6.2), où le premier champ de radiation (2.1) est disposé entre le premier réflecteur (6.1) et le premier niveau de processus (3.1) et le premier réflecteur (6.1) est disposé entre le premier réflecteur (6.1) et le premier niveau de processus (3.1) et le premier réflecteur (6.1) est conçu pour réfléchir la radiation électromagnétique du premier champ de radiation (2.1), et où le troisième champ de radiation (2.3) est disposé entre le deuxième réflecteur (6.2) et le deuxième niveau de processus (3.2) et le deuxième réflecteur (6.2) est conçu pour réfléchir la radiation électromagnétique du troisième champ de radiation (2.3).

14. Dispositif selon l'une des revendications 1 à 13, où la chambre de chauffage (HK1) et/ou la chambre de refroidissement (KK1) comprend un dispositif pour générer un vide et/ou une atmosphère gazeuse, qui contient de préférence un gaz de procédé ou un gaz inerte.

15. Procédé pour le traitement thermique continu d'au moins deux corps multicouches (4.1, 4.2) sur au moins deux niveaux de processus (3.1, 3.2), où :
a. les corps multicouches (4.1) et (4.2) sont chauffés dans au moins une chambre de chauffage (HK1) à une vitesse de chauffage de 1° C/s à 50° C/s à une température de 350° C à 800° C au moyen de champs de radiation (2.1, 2.2, 2.3), où un premier niveau de processus (3. 1) avec un premier boîtier de traitement (5.1) pour au moins un premier corps multicouche (4.1) entre un premier champ de radiation (2.1) et un deuxième champ de radiation (2.2) et un deuxième niveau de processus (3.2) avec un deuxième boîtier de traitement (5. 2) pour au moins un deuxième corps multicouche (4.2) se trouve entre le deuxième champ de radiation (2.2) et un troisième champ de radiation (2.3), où le premier niveau de processus (3.1) est irradié par le premier champ de radiation (2.1) avec une intensité de radiation différente de celle du deuxième champ de radiation (2.2) et/ou où le deuxième niveau de processus (3.2) est irradié par le deuxième champ de radiation (2.2) avec une intensité de radiation différente de celle du troisième champ de radiation (2.3), et
b. les corps multicouches (4.1) et (4.2) sont refroidis à une température de 10° C à 350° C dans au moins une chambre de refroidissement (KK1) à une vitesse de refroidissement de 0° C/s à 50° C/s.
